# EUROPEAN PATENT APPLICATION

(11) **EP 3 442 314 A1**
(43) Date of publication of application: **13.02.2019**
(21) Application number: 18187968.5
(22) Date of filing: 08.08.2018
(51) Int. Cl.: H05K 1/18, H01L 23/498, H01L 23/538

(54) **IC PACKAGE**

(30) Priority: 11.08.2017 US 201762544416 P; 24.01.2018 US 201862621444 P
(71) Applicant: Marvell Israel (M.I.S.L.) Ltd., 20692 Yokneam (IS)
(72) Inventor: AZEROUAL, Dan, 28000 Kiriat Ata (IL); BAR-LEV, Eldad, 3604631 Kiryat Tivon (IL)
(74) Representative: Grünecker Patent- und Rechtsanwälte PartG mbB

(57) **Abstract**

Aspects of the disclosure provide an integrated circuit (IC) package. The IC package includes a package substrate configured to have a first surface and a second surface that is opposite to the first surface. An IC chip is interconnected with the package substrate. The IC package includes a first plurality of contact structures disposed on the first surface to electrically couple the IC package (e.g., a first plurality of input/output (I/O) pads on the IC chip) to traces on a printed circuit board (PCB). The IC package includes a second plurality of contact structures disposed on the second surface. The second plurality of contact structures is configured to electrically couple the IC package (e.g., a second plurality of I/O pads on the IC chip) to another device via a connective structure that is independent of the PCB.

## Description

### INCORPORATION BY REFERENCE

This present disclosure claims the benefit of U.S. Provisional Application No. 62/544,416, "BGA PACKAGE WITH ON PACKAGE HIGH SPEED DATA CONNECTOR" filed on August 11, 2017, and U.S. Provisional Application No. 62/621,444, "PACKAGE BRIDGE" filed on January 24, 2018. The entire disclosures of the above-identified applications are incorporated herein by reference in their entirety.

### BACKGROUND

The background description provided herein is for the purpose of generally presenting the context of the disclosure. Work of the presently named inventors, to the extent the work is described in this background section, as well as aspects of the description that may not otherwise qualify as prior art at the time of filing, are neither expressly nor impliedly admitted as prior art against the present disclosure.

In electronic manufacturing, integrated circuit (IC) packaging is a step in the semiconductor device fabrication that encapsulates a semiconductor die (also referred to as an IC chip) of integrated circuits in a supporting case that prevents physical damage, corrosion and the like. The supporting case with the encapsulated semiconductor die is referred to as an IC package. The IC package also provides a larger surface for electrical contacts to connect the semiconductor die in the IC package to, for example, a printed circuit board (PCB).

### SUMMARY

Aspects of the disclosure provide an integrated circuit (IC) package. The IC package includes a package substrate configured to have a first surface and a second surface that is opposite to the first surface. An IC chip is interconnected with the package substrate. The IC package includes a first plurality of contact structures disposed on the first surface to electrically couple the IC package (e.g., a first plurality of input/output (I/O) pads on the IC chip) to traces on a printed circuit board (PCB). The IC package includes a second plurality of contact structures disposed on the second surface. The second plurality of contact structures is configured to electrically couple the IC package (e.g., a second plurality of I/O pads on the IC chip) to another device via a connective structure that is independent of the PCB.

In some embodiments, the second plurality of contact structures is disposed on the second surface in a form of a two-dimensional array of contact structures. In an example, the IC chip is disposed on the second surface, and the second plurality of contact structures is disposed on the second surface in a peripheral area between the IC chip and an edge of the package substrate.

According to an aspect of the disclosure, the second plurality of contact structures is configured to couple a communication cable to a second plurality of I/O pads. In some examples, the IC package includes a connector that is attached to the IC package. The connector has a first connector interface configured to electrically connect with the second plurality of contact structures, and has a second connector interface configured to electrically connect with the communication cable.

In an example, the second plurality of contact structures includes two contact structures that are electrically coupled to a differential pair of I/O pads on the IC chip, and the two contact structures are configured to electrically couple the differential pair of I/O pads with two conductors in a twin-axial cable.

In some embodiments, the second plurality of contact structures includes multiple pairs of contact structures that are electrically coupled to multiple differential pairs of I/O pads on the IC chip, and the multiple pairs of contact structures are configured to mechanically accept a plug for electrically connecting the multiple pairs of contact structures with multiple twin-axial cables.

In some examples, the two contact structures are configured to be electrically connected to a port device on the PCB via the twin-axial cable. In another example, the port device is on a different PCB.

In some embodiments, the second plurality of contact structures are configured to connect with corresponding contact structures disposed on a second IC package via a multi-layer planar connective structure that is external to the PCB. For example, the second plurality of contact structures is configured to connect with the corresponding contact structures on the second IC package via traces that are disposed within the multi-layer planar connective structure.

In some examples, the second plurality of contact structures are configured to connect with corresponding contact structures on a second IC package via interconnectors that are assembled within a rigid substrate of a package bridge.

In some embodiments, the second plurality of contact structures are disposed to form multiple groups of contact structures that are configured to respectively connect with corresponding contact structures on multiple second IC packages via respective package bridges.

According to some embodiments, the first plurality of contact structures is configured to input/output signals of first speeds, and the second plurality of contact structures is configured to input/output signals of second speeds that are higher than the first speeds.

In some embodiments, the second plurality of contact structures is configured to couple the second plurality of I/O pads on the IC chip to the other device via the connective structure that causes less signal attenuation than the PCB.

Aspects of the disclosure provide a method of semiconductor device fabrication. The method includes forming a package substrate of an integrated circuit (IC) package for packaging an IC chip. The package substrate has a first surface and a second surface that is opposite to the first surface. The method further includes disposing a first plurality of contact structures on the first surface. The first plurality of contact structures is configured to be electrically coupled with traces on a printed circuit board (PCB) when the IC package is mounted to the PCB. Further, the method includes disposing a second plurality of contact structures on the second surface. The second plurality of contact structures is configured to be electrically coupled with a connective structure that is independent of the PCB.

In some embodiments, the method includes attaching a connector to the IC package with a first connector interface being electrically connected with the second plurality of contact structures. In some examples, the method further includes plugging a communication cable into a second connector interface of the connector to electrically connect the second plurality of contact structures with the communication cable. For example, the method includes plugging the communication cable into the second connector interface of the connector to electrically connect two conductors of a twin-axial cable within the communication cable to two contact structures within the second plurality of contact structures. The two contact structures are connected to a pair of differential inputs/outputs in the IC chip.

In some examples, the method includes mounting the IC package to the PCB with the first plurality of contact structures being electrically coupled with the traces on the PCB, and attaching a multi-layer planar connective structure that is external to the PCB to the IC package to connect the second plurality of contact structures with corresponding contact structures on a second IC package via traces that are disposed in the multi-layer planar connective structure

Aspects of the disclosure provide a method for configuring (e.g., designing and/or manufacturing) an integrated circuit (IC) package for an IC chip. The IC package includes a package substrate that has a first surface and a second surface opposite to the first surface. The method includes configuring the IC package to route first interconnections from first input/output (I/O) pads on the IC chip to first contact structures on the first surface of the package substrate. The first contact structures are used to couple the first I/O pads to traces on a printed circuit board (PCB). The method further includes configuring the IC package to route second interconnections from second I/O pads on the IC chip to second contact structures on the second surface of the package substrate. The second contact structures are used to couple the second I/O pads to another device via a connective structure that is independent of the PCB.

In some embodiments, the method includes configuring the IC package to route the first interconnections from the first I/O pads on the IC chip to the first contact structures for inputting/outputting signals of first speeds, and configuring the IC package to route the second interconnections from the second I/O pads to the second contact structures for inputting/outputting signals of second speeds that are higher than the first speeds.

In some embodiments, the method includes configuring the IC package to route the first interconnections from the first I/O pads on the IC chip to the first contact structures for inputting/outputting first signals, and configuring the IC package to route the second interconnections from the second I/O pads to the second contact structures for inputting/outputting second signals that are more sensitive to signal attenuation than the first signals.

### BRIEF DESCRIPTION OF THE DRAWINGS

Various embodiments of this disclosure that are proposed as examples will be described in detail with reference to the following figures, wherein like numerals reference like elements, and wherein:
Figs. 1A-1C show different views of an integrated circuit (IC) package 100 according to some embodiments of the disclosure;
Fig. 2 shows a cross-sectional view of another IC package 200 according to some embodiments of the disclosure;
Fig. 3 shows a schematic view of an electronic device 301 according to some embodiments of the disclosure;
Figs. 4A and 4B show different views of a PCB 402 according to some embodiments of the disclosure; and
Fig. 5 shows a flow chart outlining a process example 500 according to some embodiments of the disclosure.

### DETAILED DESCRIPTION OF EMBODIMENTS

Aspects of the disclosure provide an integrated circuit (IC) package that encapsulates one or more IC chips. The IC package includes a package substrate for mechanical support and electrical support. The package substrate has a first surface and a second surface that is opposite the first surface. Further, the IC package includes a first plurality of contact structures, such as contact pads, solder balls, and the like, that is formed on the first surface of the package substrate, and includes a second plurality of contact structures that is formed on a second surface of the package substrate. The first plurality of contact structures and the second plurality of contact structures interface the IC chips in the IC package to components out of the IC package. In an example, when the IC package is mounted on a printed circuit board (PCB), the first plurality of contact structures is connected to corresponding contact structures on the PCB. Further, other connective structures that are independent of the PCB are used to connect the second plurality of contact structures to other devices on the PCB or out of the PCB.

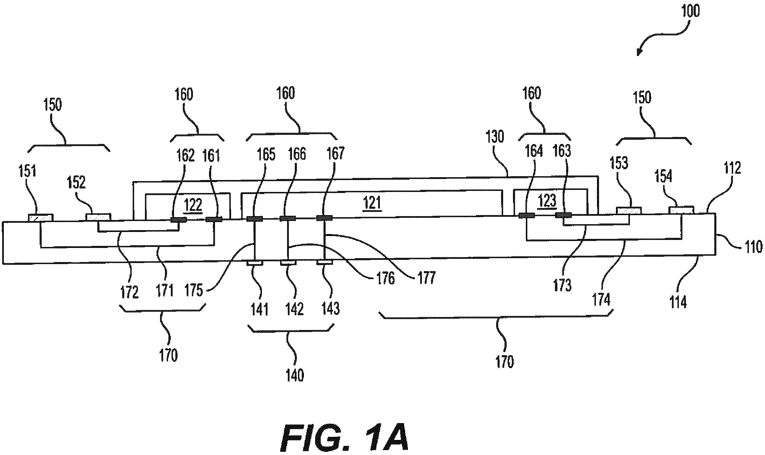

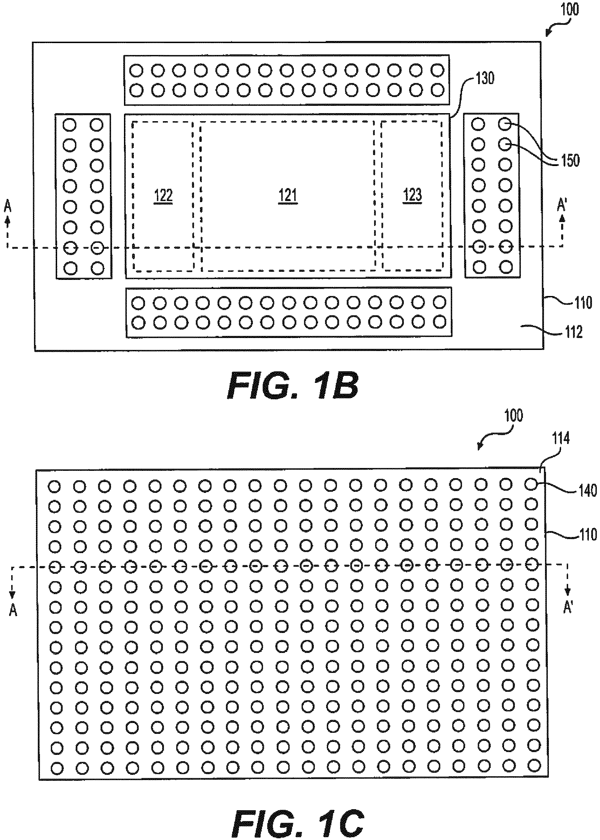

Figs. 1A-1C show different views of an IC package 100 according to some embodiments of the disclosure. Fig. 1B shows a top view of the IC package 100 and the Fig. IC shows a bottom view of the IC package 100. Fig. 1A shows a cross-sectional view of the IC package 100 along a line A-A' shown in Fig. 1B and Fig. 1C. The IC package 100 encapsulates one or more IC chips, such as IC chips 121-123 that are packaged in the IC package 100.

The IC package 100 includes a package substrate 110 that has a first surface 114 and a second surface 112 that is opposite of the first surface 114. The package substrate 110 is made for example of suitable insulating material (also referred to as dielectric material), such as an epoxy based laminate substrate, a resin-based Bismaleimide-Triazine (BT) substrate, and the like. The package substrate 110 is relatively rigid to provide mechanical support to the IC chips 121-123. The IC chips 121-123 are disposed on a surface, such as the second surface 112 of the package substrate 110. Further, in some examples, the IC package 100 includes a metal cover 130 that covers the IC chips 121-123 to aid in rapid heat dissipation during operation when the IC chips 121-123 are powered on, in an embodiment.

The package substrate 110 also provides electrical support for the IC chips 121-123. In some examples, the package substrate 110 includes multiple layers of metal traces, such as copper wires, and the like with the insulating material in between. The metal traces on the different layers can be connected by vias. Further, contact structures are formed on both the first surface 114 and the second surface 112 to electrically interface the IC chips 121-123 in the IC package 100 to components out of the IC package 100.

The IC chips 121-123 can be any suitable chips. The IC chips 121-123 include various circuits for providing computing and/or processing functionalities. In some examples, the IC chips 121-123 receive suitable signals, such as analog signals, digital signals, control signals, data signals and the like, from components out of the IC package 100, and process the received signals. In some examples, the IC chips 121-123 generate suitable signals, such as analog signals, digital signals, control signals, data signals, and the like, and outputs the generated signals to the components that out of the IC package 100.

In an embodiment, the IC package 100 is used in a high speed network switch equipment for packet switching. For example, the IC chip 121 is a core chip for packet processing, and the IC chips 122 and 123 are peripheral chips for interface (input/output) processing, such as receiving and/or transmitting signals carrying packets. The IC chip 121 is interconnected with the IC chips 122 and 123. In an example, the IC chip 121 includes one or more packet processors configured to perform packet processing, including but not limited to packet forwarding. The IC chips 122 and 123 respectively include interface circuits, such as modulation/demodulation circuits, memory circuit for queuing packets, and the like. In an example, the IC chips 122 and 123 include Serializer/Deserializer (SERDES) configured to convert data between serial data and parallel data. Further, in an example, the IC chips 122 and 123 include modulation/demodulation circuits of a suitable modulation technique, such as pulse-amplitude modulation (PAM)-4, PAM-8, and the like. In addition, in an example, the IC chips 122 and 123 include encoding/decoding circuits of a suitable coding technique, such as non-return-to-zero (NRZ), non-return-to-zero-inverted (NRZI), return-to-zero (RZ), and the like.

The package substrate 110 provides interconnects from the inputs/outputs of the IC chips 121-123 to the contact structures that are formed on the first surface 114 and the second surface 112 of the IC package 100. In an example, the IC chips 121-123 are flip chips. The IC chips 121-123 include input/output (I/O) pads (not shown) that are electrically connected to internal circuits that are formed on the IC chips 121-123. Then, solder bumps are deposited on the I/O pads by suitable manufacturing process to form bump-out structures on the surface of the flip chips. The second surface 112 of the package substrate 110 includes solder bumps 160 that match the bump-out structures on the IC chips 121-123. In an example, the IC chips 121-123 are disposed on the second surface 112, such that the bump-out structures on the IC chips 121-123 are aligned with the solder bumps 160 on the second surface 114 of the package substrate 110. Then, a reflow process is performed to form connections of the bump-out structures and the solder bumps 160.

It is noted that, in another example, the IC chips 121-123 can be wire-bonded to form electrical connections with the package substrate 110.

In the example shown in Figs. 1A-1C, the package substrate 110 includes first contact structures 140 formed on the first surface 114 and second contact structures 150 formed on the second surface 112. Further, the package substrate 110 includes metal traces 170 that electrically connect the solder bumps 160 to the first contact structures 140 and the second contact structures 150. For example, a metal trace 171 (e.g., including plated vias, copper wires, ...) connects a solder bump 161 with a contact structure 151; a metal trace 172 (e.g., including plated vias, copper wires, ...) connects a solder bump 162 with a contact structure 152; a metal trace 173 (e.g., including plated vias, copper wires,...) connects a solder bump 163 with a contact structure 153; a metal trace 174 (e.g., including plated vias, copper wires,...) connects a solder bump 164 with a contact structure 154; a metal trace 175 (e.g., plated through hole via 175) connects a solder bump 165 with a contact structure 141; a metal trace 176 (e.g., plated through hole via 176) connects a solder bump 166 with a contact structure 142; and a metal trace 177 (e.g., plated through hole via 177) connects a solder bump 167 with a contact structure 143.

The first contact structures 140 and the second contact structures 150 can be any suitable contact structures. In an embodiment, the IC package 100 is a ball grid array (BGA) package, and each of the first and second contact structures 140 and 150 includes a solder pad and a solder ball that is deposited on the solder pad. In another embodiment, the IC package 100 is a land grid array (LGA) package, and each of the first and second contact structures 140 and 150 includes a solder pad. In another embodiment, the 1C package 100 is a pin grid array (PGA) package, and each of the first and second contact structures 140 and 150 includes a pin.

It is noted that, in some embodiments, the second contact structures 150 are implemented using a different technology from the first contact structures 140. For example, the first contact structures 140 are implemented using solder pads and solder balls, and the second contact structures 150 are implemented using pins.

In the example of Figs. 1B-1C, the first and second contact structures 140 and 150 are shown as circles. In some examples, the first and second contact structures 140 and 150 have other suitable shapes, such as a sphere, a square, a pin shape, and the like.

According to an aspect of the disclosure, the first contact structures 140 and the second contact structures 150 are respectively configured to enable electrical connections to other components using suitable techniques. In an example, the first contact structures 140 are configured to enable electrical connections to a printed circuit board (PCB), and the second contact structures 150 are configured to enable electrical connections that are independent of the PCB. For example, when the IC package 100 is mounted on a PCB, the first contact structures 140 are connected to corresponding contact structures on the PCB. Further, in an embodiment, one or more connective structures, such as flexible communication cables, partly flexible or rigid package bridges, and the like that are independent of the PCB, are used to connect the second contact structures 150 to other electronic components, such as another IC package, a port connector for a communication cable, and the like.

In some embodiments, the second contact structures 150 are configured for high speed data input/output. In an example, the IC chip 122 and the IC chip 123 respectively includes multiple SERDES circuits (not shown) to generate or process differential signal pairs. For example, the IC chip 122 includes a SERDES circuit configured to receive/transmit a pair of differential signals from/to a pair of I/O pads that are respectively connected with the solder bumps 161 and 162. The solder bumps 161 and 162 are respectively connected to the second contact structures 151 and 152 via the metal traces 171 and 172. The SERDES circuit is configured to operate at a relatively high data rate, such as 28 gigabit per second (Gbps), 56 Gbps, 112 Gbps, over 112 Gbps, and the like.

According to an aspect of the disclosure, the metal traces 170 are suitably routed during IC package design to interconnect the I/O pads of the IC chips to the first contact structures 140 and the second contact structures 150. In an example, the IC package 100 is configured to route the first interconnections (e.g., metal traces 175-177,...) from the first I/O pads (e.g., corresponding to the solder bumps 165-167) on the IC chips 121-123 to the first contact structures 141-143 for inputting/outputting signals of first speeds. Further, the IC package 100 is configured to route the second interconnections (e.g., metal traces 171-174,...) from the second I/O pads (e.g., corresponding to the solder bumps 161-164) on the IC chips 121-123 to the second contact structures 151-154 for inputting/outputting signals of second speeds that are higher than the first speeds.

In another example, the IC package 100 is configured to route the first interconnections (e.g., metal traces 175-177,...) from the first I/O pads (e.g., corresponding to the solder bumps 165-167) on the IC chips 121-123 to the first contact structures 141-143 for inputting/outputting first signals. Further, the IC package 100 is configured to route the second interconnections (e.g., metal traces 171-174,...) from the second I/O pads (e.g., corresponding to the solder bumps 161-164) on the IC chips 121-123 to the second contact structures 151-154 for inputting/outputting second signals that are more sensitive to signal attenuation that the first signals.

According to an aspect of the disclosure, the second contact structures 150 and the IC chips 121-123 are disposed on the same surface side of the package substrate 110. In some embodiments, the second contact structures 150 are disposed at a peripheral area that surrounds the IC chips 121-123, such as the area between the IC chips 121-123 and an edge of the second surface 112.

In some embodiments, twin-axial cables are used to transmit high speed data input/output to an external interface such as a switch port. In an example, a twin-axial cable includes two inner conductors configured to transmit a pair of differential signals. The two inner conductors are suitably insulated and surrounded by an insulating layer (e.g., tubular insulating layer) and then surrounded by a conducting shield (e.g., tubular conducting shield). The twin-axial cable also has an insulating outer sheath or jacket. In some embodiments, connectors are used to couple the contact structures on the second surface 112 to twin-axial cables.

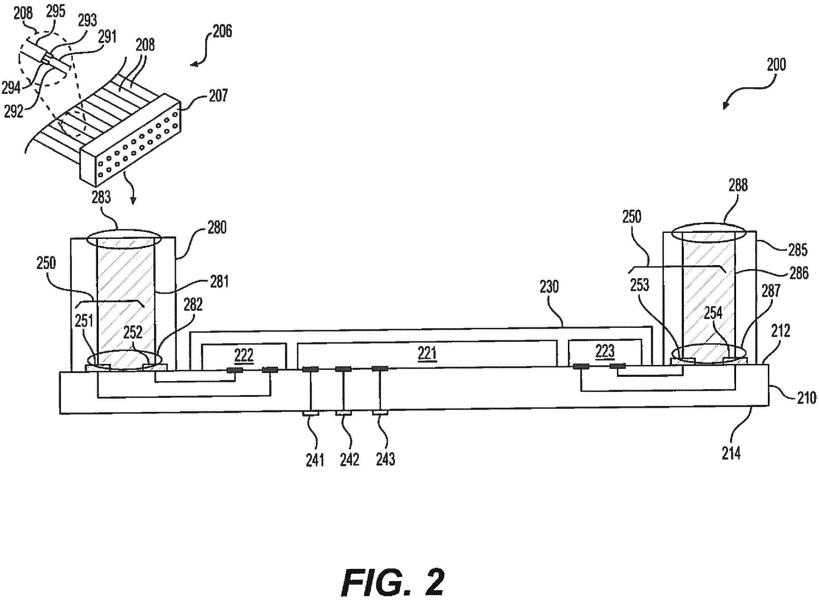

Fig. 2 shows a cross-sectional view of an IC package 200 with connectors 280 and 285 being attached on the IC package 200 according to some embodiments of the disclosure. The IC package 200 utilizes certain components that are identical or equivalent to those used in the IC package 100; the description of these components has been provided above and will be omitted here for clarity purposes.

In the Fig. 2 example, a connector 280 includes multiple connecting modules. For example, a connecting module 281 includes a first interface structure 282 and a second interface structure 283. The first interface structure 282 includes two connecting parts that are respectively connected to the second contact structures 251 and 252, and the second interface structure 283 is configured to couple with a twin-axial cable 208.

In an example, the second contact structures 250 are arranged in an array for multiple pairs of differential signals. The connector 280 includes, in an embodiment, multiple connecting modules to couple the array of the second contact structures 250 to multiple twin-axial cables respectively for transmitting the multiple pairs of differential signals. In an example, the multiple twin-axial cables are separately connected to different components at the other ends of the multiple twin-axial cables. In another example, the multiple twin-axial cables are combined into a master cable, and the other ends of the multiple twin-axial cables are connected to another connector. In another example, the master cable can be split into sub-cables, and the sub-cables are connected to different components at the other ends of the sub-cables.

Fig. 2 also shows a schematic plot of a cable 206 according to some embodiments of the disclosure. The cable 206 includes a connector 207 configured to match with the connector 280, and can be plugged into the connector 280. The cable 206 includes multiple twin-axial cables 208 that are suitably combined into a master cable.

Fig. 2 shows a close up view of a twin-axial cable 208 according to some embodiments. In an example, the twin-axial cable 208 includes two inner conductors 291 and 292 configured to transmit a pair of differential signals. The two inner conductors 291 and 292 are suitably insulated and surrounded by tubular insulating layers 293 and 294 respectively and then surrounded by a conducting shield (not shown) and an insulating outer sheath 295.

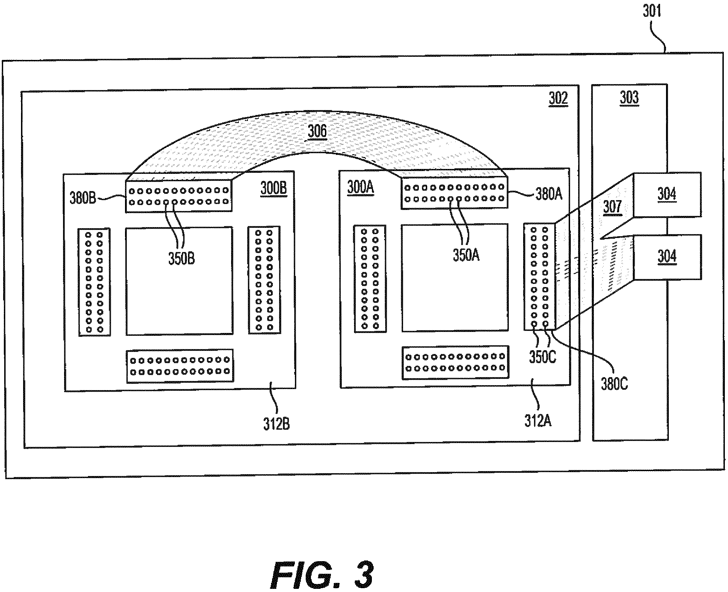

Fig. 3 shows a schematic view of an electronic device 301 according to some embodiments of the disclosure. The electronic device 301 can be any suitable device, such as a network switch, a network bridge, a network access point, a network router, a server device, a computer, a desktop computer, a laptop computer, a tablet computer, and the like. The electronic device 301 includes an IC package 300A that is similarly configured as the IC package 100. The IC package 300A utilizes certain components that are identical or equivalent to those used in the IC package 100; the description of these components has been provided above and will be omitted here for clarity purposes.

In the Fig. 3 example, the IC package 300A is mounted on a printed circuit board (PCB) 302. For example, Fig. 3 shows a top view of the IC package 300A, and the second surface 312A of the IC package 300A. The first surface (not shown) of the IC package 300 A includes the first contact structures (not shown) that are similarly configured as the first contact structures 140 in the Fig. 1 example. When the IC package 300A is mounted on the PCB 302, the first contact structures of the IC package 300A are connected to corresponding contact structures on the PCB 302. The PCB 302 includes metal traces to route signals to/from the first contact structures to connect the first contact structures to other components on the PCB 302.

Further, the IC package 300A includes second contact structures, such as second contact structures 350A, second contact structures 350B, and the like that are formed on the second surface 312A of the IC package 300A, In an embodiment, as depicted in Fig. 3, second surface 312A is opposite PCB 302 and thus exposed. The second contact structures 350B are connected to other electronic components via cables, such as a first master cable 306, a second master cable 307, and the like that are independent of the PCB 302. The cables can connect the IC package 300A to other components on the PCB 302 or outside of the PCB 302.

For example, another IC package 300B is mounted on the PCB 302. The IC package 300B is similarly configured as the IC package 100. The IC package 300B utilizes certain components that are identical or equivalent to those used in the IC package 100; the description of these components has been provided above and will be omitted here for clarity purposes. Further, a connector 380A is mechanically and electrically attached to the contact structures 350A of the IC package 300A. Similarly, a connector 380B is mechanically and electrically attached to an array of the contact structures 350B of the IC package 300B. The connector 380A and the connector 380B are similarly configured as the connectors 280 in Fig. 2; the description of these components has been provided above and will be omitted here for clarity purposes.

In an example, the master cable 306 has two end plugs that are respectively plugged into the connector 380A and the connector 380B. The master cable 306 includes multiple twin-axial cables to transmit multiple pairs of differential signals between the IC package 300A and IC package 300B. In the example seen in Fig. 3, the connector 380A is coupled to the array that includes twelve pairs of contact structures 350A, the connector 380B is coupled to the array that includes twelve pairs of contact structures 350B, and the master cable 306 includes twelve twin-axial cables to transmit twelve pairs of differential signals between the IC package 300A and the IC package 300B.

It is noted that the number twelve is used as an example, and the master cable 306 can include any suitable number of twin-axial cables or other suitable cables to transmit differential signals or non-differential signals between the IC package 300A and the IC package 300B.

In an embodiment, the electronic device 301 is a network switch for packet switching. The electronic device 301 includes network port interfaces 304 with suitable mechanical and electrical design to couple communication cables, such as Ethernet cables, and the like. For example, Ethernet cables are plugged into the network port interfaces 304 to connect the electronic device 301 to other devices, such as other network devices, terminal devices, and the like.

In some examples, the IC package 300A includes one or more integrated circuits bearing packet processing circuits, interface circuits and the like. The interface circuits include SERDES circuits to process differential signals. For example, the IC package 300A receives a pair of differential signals that carries serial data, and a SERDES circuit in the IC package 300A processes the pair of differential signals to generate parallel data. The parallel data can be further processed by other internal circuits in the IC package 300A. In another example, some internal circuits of the IC package 300A generate parallel data for output, and a SERDES circuit in the IC package 300A converts the parallel data to seral data in the form of a pair of differential signals for transmitting out of the IC package 300A.

In the Fig. 3 example, the IC package 300A and the network port interfaces 304 are connected by the master cable 307. For example, a connector 380C is mechanically and electrically attached to an array of the second contact structures 350C of the IC package 300A. The master cable 307 has an end plug plugged into the connector 380C. The master cable 307 includes multiple twin-axial cables to transmit multiple pairs of differential signals. The master cable 307 is split into sub-cables, the sub-cables are installed with suitable end plugs that can connect with the network port interfaces 304, in embodiment. For example, the connector 380C is coupled to the array that includes twelve pairs of second contact structures 350C, the master cable 307 is split into two sub-cables that each includes six twin-axial cables. Each sub-cable includes an end plug that can be plugged into one of the network port interfaces 304.

It is noted that, the master cable 307 can include any suitable number of twin-axial cables or other suitable flexible cables and connectors separate from PCB 302 to transmit differential signals or other suitable signals between the IC package 300A and the network port interfaces 304.

It is also noted that in an example, the IC package 300A and the network port interface 304 are disposed on the same PCB 302. In another example, the network port interfaces 304 are disposed on a different PCB 303.

In various examples of the present disclosure, electrical connections from an IC package to other electronic components are implemented via contact structures on multiple surfaces of the package substrate, various benefits can be achieved compared to a related example. In the related example, electrical connections from an IC package to other electronic components are via metal traces in a PCB. Due to various attenuations, such as attenuation due to plated through hole (PTH) via on the IC package, attenuation due to PTH via on the PCB, attenuation due to dielectric loss on PCB, the maximum routing length is limited.

In some embodiments of the present disclosure, electrical connections from the IC package 300A to other electronic components are implemented via metal traces in the PCB 302 and via connective structures that are independent of the PCB 302, such as cables (e.g., the master cables 306 and 307), thus the PCB 302 can be implemented with a relatively smaller number of metal trace layers, in an embodiment. Further, in some examples, high speed signals are transmitted using cables (e.g., twin-axial cables), and thus the PCB 302 can be implemented using relatively inexpensive insulating material. Further, the maximum routing length in the embodiments according to the present disclosure is longer than the maximum routing length in the related example.

It is noted that other suitable connective structures can be used to connect, for example, the IC package 100 to other electronic devices via the second contact structures 150.

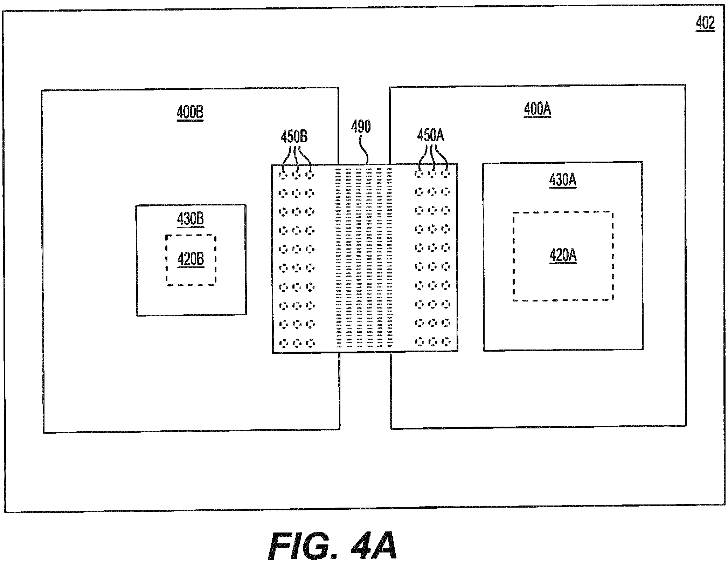

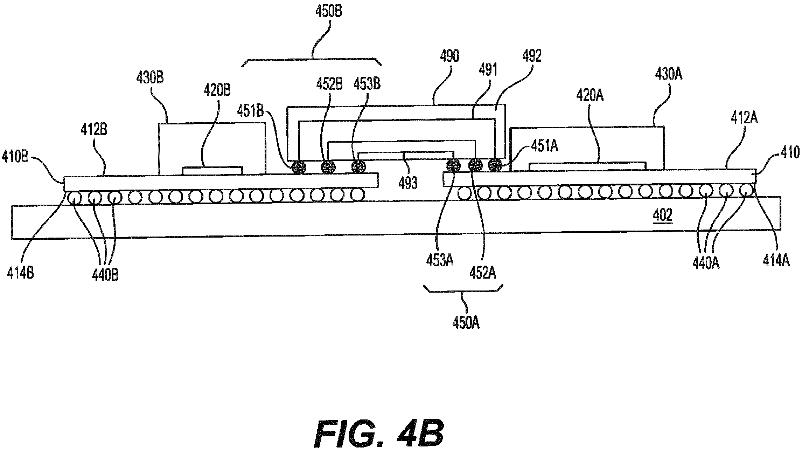

Figs. 4A and 4B show different views of a PCB 402 according to some embodiments of the disclosure. Fig. 4A shows a top view of the PCB 402, and the Fig. 4B shows a cross-sectional view of the PCB 402.

In the example of Figs 4A and 4B, two IC packages 400A and 400B are mounted on the PCB 402. The two IC packages 400A and 400B utilize certain components that are identical or equivalent to those used in the IC package 100. For example, the IC package 400A includes an IC chip 420A that is covered by a metal lid 430A, the IC package 400B includes an IC chip 420B that is covered by a metal lid 430B. The description of these components has been provided above and will be omitted here for clarity purposes.

In the example of Fig. 4B, the IC package 400A includes first contact structures 440A on the first surface 414A. The first contact structures 440A are similarly configured as the first contact structures 140 in the Figs. 1A-1C example. When the IC package 400A is mounted on the PCB 402, the first contact structures 440A are connected to corresponding contact structures on the PCB 402. Similarly, the IC package 400B includes first contact structures 440B on the first surface 414B. The first contact structures 440B are similarly configured as the first contact structures 140 in the Figs. 1A-1C example. When the IC package 400B is mounted on the PCB 402, the first contact structures 440B are connected to corresponding contact structures on the PCB 402. The PCB 402 includes multiple layers of metal traces, such as copper wires, and the like disposed on a multilayered sandwich structure of dielectric material. The metal traces are used to route signals to/from the first contact structures 440A and 440B.

In an embodiment, the IC package 400A and the IC package 400B are interconnected via a package bridge 490. For example, the IC package 400A and the IC package 400B are mounted on the PCB 402 adjacent each other, and the package bridge 490 is suitably attached as a bridging device coupling between the IC package 400A and the IC package 400B. First electrical connections are formed in the package bridge 490 and the second contact structures 450A on the IC package 400A, and the second electrical connections are formed of the package bridge 490 and the second contact structures 450B (Fig. 4B). The package bridge 490 then interconnects the second contact structures 450A and the second contact structures 450B.

In some embodiments, the package bridge 490 has a multi-layer planar connective structure that is relatively rigid. The package bridge 490 includes wires that are pre-routed and pre-formed at fixed positions in the package bridge 490. In an example, the package bridge 490 is formed in a similar manner to a PCB or package substrate. The PCB is formed of suitable insulating material, such as an epoxy based laminate substrate, a resin-based Bismaleimide-Triazine (BT) substrate, and the like. The PCB includes multiple layers of metal traces, such as copper wires, and the like with the insulating material in between. The metal traces on the different layers can be connected by vias. The metal traces are routed to interconnect the corresponding second contact structures of the IC package 400A and the IC package 400B. In the Fig. 4B example, a metal trace 491 interconnects a contact structure 451A of the IC package 400A with a corresponding contact structure 451B of the IC package 400B; a metal trace 492 interconnects a contact structure 452A of the IC package 400A with a corresponding contact structure 452B of the IC package 400B; a metal trace 493 interconnects a contact structure 453A of the IC package 400A with a corresponding contact structure 453B of the IC package 400B.

It is noted that various techniques can be used to form electrical connections between the package bridge 490 and the IC package 400A or the IC package 400B. In an example, electrical connections are formed using soldering techniques.

It is noted that, the PCB in the package bridge 490 is relatively small compared to the PCB 402. In an example, the PCB in the package bridge 490 is implemented using relatively expensive material (with less dielectric loss), such as a material that is know as MEGTRON 6, and the like to enable high speed transmission for specific signals (e.g., serial data in the form of differential signals) between the IC package 400A and the IC package 400B. The PCB in the package bridge 490 causes less signal attenuation for high speed signals compared to the PCB 402 in some examples.

According to some aspects of the disclosure, routing paths from the IC package 400A to the IC package 400B are implemented via metal traces in the PCB 402 and via the package bridge 490 that is independent of the PCB 402, thus the PCB 402 can be implemented with a relatively smaller number of metal trace layers. Further, in some examples, high speed signals, and or signals requiring a particularly high level of signal to noise ratio are transmitted using the package bridge 490, while other signals that are more resilient to noise are transmitted through the PCB, thereby enabling the PCB 402 to be implemented using relatively inexpensive technologies, such as less expensive insulating materials and/or fewer layers. In an embodiment, this results in an overall cost savings by avoiding the necessity of making the entire PCB using very high cost fabrication technologies, in some cases.

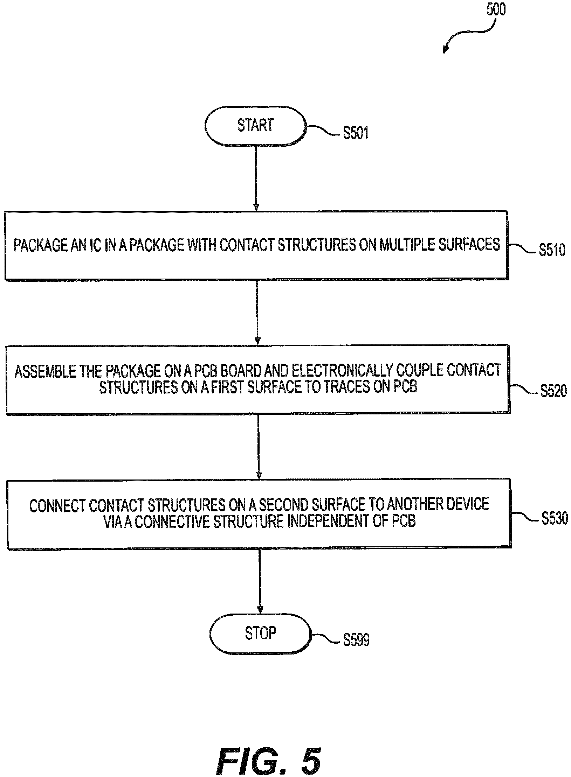

Fig. 5 shows a flow chart outlining a process example 500 according to some embodiments of the disclosure. In an example, the process 500 is used to form an IC package, such as the IC package 100, the IC package 200, and the like, and assemble the IC package on a PCB board, such as the PCB 302, the PCB 402 and the like. The process starts at S501 and proceeds to S510.

At S510, an IC chip is packaged in an IC package with contact structures on multiple surfaces of a package substrate, opposing surfaces of a planar substrate. In an example, the package substrate 110 is formed. The package substrate 110 has the first surface 114 and the second surface 112. Then, in an example, the first contact structures 140 are formed on the first surface 114, and the second contact structure 150 are formed on the second surface 112, opposite the first surface 114. In an embodiment, solder bumps 160 are formed on the second surface 114. In an example, the IC chips 121-123 are disposed on the second surface 112, such that the bump-out structures on the IC chips 121-123 are aligned with the solder bumps 160 on the second surface 114 of the package substrate 110. Then, a reflow process is performed to form connections of the bump-out structures and the solder bumps 160. Further, the metal lid 130 is formed to partially or completely cover IC chips 121-123.

At S520, the IC package is mounted on a PCB. In an example, the IC package 100 is mounted on a PCB board, the first contact structures 140 are connected to corresponding contact structures on the PCB.

As seen in the Figs. 4A-4B example, when the IC package 400A and 400B are mounted on the PCB 402, the first contact structures 440A and the first contact structures 440B are connected to corresponding contact structures on the PCB 402.

At S530, contact structures on the second surface are connected to another electrical component via a connective structure that is independent of the PCB.

As seen in the Fig. 3 example, the connector 380A is attached to the IC package 300A and connected to the second contact structures 350A, the connector 380B is attached to the IC package 300B and connected to the second contact structures 350B, and the connector 380C is attached to the IC package 300A and connected to the second contact structures 350C. In the embodiment seen in Fig. 3, the two end plugs of the master cable 306 are respectively plugged into the connector 380A and the connector 380B thereby respectively electrically coupling IC package 300A and IC package 300B externally to the PCB 302 upon which both packages are mounted. The three end plugs of the master cable 307 are plugged into the connector 380C and the network port interfaces 304, respectively, thereby respectively electrically coupling the IC package 300A to the network port interfaces 304. The master cable 307 is external to any PCB upon which the IC packages 300A and 300B and network port interfaces 304 are mounted.

In the Figs. 4A-4B example, the package bridge 490 is attached with the IC package 400A and connected to the second contact structures 450A. The package bridge 490 is also attached with the IC package 400B and connected to the second contact structures 450B. The package bridge 490 interconnects the IC package 400A and the IC package 400B externally to PCB 402.

It is noted that, in various embodiments, other suitable process steps can be performed before the process 500, between steps in the process 500 and/or after the process 500 for semiconductor device fabrication. The process then proceeds to S599 and terminates.

While aspects of the present disclosure have been described in conjunction with the specific embodiments thereof that are proposed as examples, alternatives, modifications, and variations to the examples may be made. Accordingly, embodiments as set forth herein are intended to be illustrative and not limiting. There are changes that may be made without departing from the scope of the claims set forth below.

**The following is a list of further preferred embodiments of the invention:**
Embodiment 1. An integrated circuit (IC) package, comprising:
   a package substrate configured to have a first surface and a second surface being opposite to the first surface;
   an IC chip that is interconnected with the package substrate;
   a first plurality of contact structures disposed on the first surface of the package substrate to electrically couple the IC package to traces on a printed circuit board (PCB);
   a second plurality of contact structures disposed on the second surface of the package substrate, the second plurality of contact structures being configured to electrically couple the IC package to another device via a connective structure that is independent of the PCB.
Embodiment 2. The IC package of embodiment 1, wherein the second plurality of contact structures is disposed on the second surface in a form of a two-dimensional array of contact structures.
Embodiment 3. The IC package of embodiment 1, wherein the second plurality of contact structures is configured to couple a communication cable to a second plurality of I/O pads on the IC chip.
Embodiment 4. The IC package of embodiment 3, further comprising:
   a connector that is attached to the IC package, the connector having a first connector interface configured to electrically connect with the second plurality of contact structures, and having a second connector interface configured to electrically connect with the communication cable.
Embodiment 5. The IC package of embodiment 3, wherein the second plurality of contact structures includes two contact structures that are electrically coupled to a differential pair of I/O pads on the IC chip, and the two contact structures are configured to electrically couple the differential pair of I/O pads with two conductors in a twin-axial cable.
Embodiment 6. The IC package of embodiment 5, wherein the second plurality of contact structures includes multiple pairs of contact structures that are electrically coupled to multiple differential pairs of I/O pads on the IC chip, and the multiple pairs of contact structures are configured to mechanically accept a plug for electrically connecting the multiple pairs of contact structures with multiple twin-axial cables.
Embodiment 7. The IC package of embodiment 5, wherein the two contact structures are configured to be electrically connected to a port device on the PCB via the twin-axial cable.
Embodiment 8. The IC package of embodiment 5, wherein the two contact structures are configured to be electrically connected to a port device that is off of the PCB via the twin-axial cable.
Embodiment 9. The IC package of embodiment 1, wherein the IC chip is disposed on the second surface, and the second plurality of contact structures is disposed on the second surface in a peripheral area between the IC chip and an edge of the package substrate.
Embodiment 10. The IC package of embodiment 1, wherein:
   the second plurality of contact structures are configured to connect with corresponding contact structures disposed on a second IC package via a multi-layer planar connective structure that is external to the PCB.
Embodiment 11. The IC package of embodiment 10, wherein:
   the second plurality of contact structures are configured to connect with the corresponding contact structures on the second IC package via traces that are disposed within the multi-layer planar connective structure.
Embodiment 12. The IC package of embodiment 1, wherein:
   the second plurality of contact structures are configured to connect with corresponding contact structures on a second IC package via interconnectors that are assembled within a rigid substrate of a package bridge.
Embodiment 13. The IC package of embodiment 12, wherein:
   the second plurality of contact structures are disposed to form multiple groups of contact structures that are configured to respectively connect with corresponding contact structures on multiple second IC packages via respective package bridges.
Embodiment 14. The IC package of embodiment 1, wherein
   the first plurality of contact structures is configured to input/output signals of first speeds; and
   the second plurality of contact structures is configured to input/output signals of second speeds that are higher than the first speeds.
Embodiment 15. The IC package of embodiment 1, wherein
   the second plurality of contact structures is configured to couple a second plurality of I/O pads on the IC chip to the other device via the connective structure that causes less signal attenuation than the PCB.
Embodiment 16. A method, comprising:
   forming a package substrate of an integrated circuit (IC) package for packaging an IC chip, the package substrate having a first surface and a second surface being opposite to the first surface;
   disposing a first plurality of contact structures on the first surface, the first plurality of contact structures being configured to be electrically coupled with traces on a printed circuit board (PCB) when the IC package is mounted to the PCB; and
   disposing a second plurality of contact structures on the second surface, the second plurality of contact structures being configured to be electrically coupled with a connective structure that is independent of the PCB, the connective structure coupling the IC chip to a device separate from the IC chip.
Embodiment 17. The method of embodiment 16, further comprising:
   attaching a connector to the IC package with a first connector interface being electrically connected with the second plurality of contact structures.
Embodiment 18. The method of embodiment 17, further comprising:
   plugging a communication cable into a second connector interface of the connector to electrically connect the second plurality of contact structures with the communication cable.
Embodiment 19. The method of embodiment 18, further comprising:
   plugging the communication cable into the second connector interface of the connector to electrically connect two conductors of a twin-axial cable within the communication cable to two contact structures within the second plurality of contact structures, the two contact structures being connected to a pair of differential inputs/outputs in the IC chip.
Embodiment 20. The method of embodiment 16, further comprising:
   mounting the IC package to the PCB with the first plurality of contact structures being electrically coupled with the traces on the PCB; and
   attaching a multi-layer planar connective structure that is external to the PCB to the IC package to connect the second plurality of contact structures with corresponding contact structures on a second IC package via traces that are disposed in the multi-layer planar connective structure.
Embodiment 21. The method of embodiment 16, further comprising:
   configuring the IC package to route first interconnections from first I/O pads on the IC chip to the first plurality of contact structures for inputting/outputting signals of first speeds;
   configuring the IC package to route second interconnections from second I/O pads on the IC chip to the second plurality of contact structures for inputting/outputting signals of second speeds that are higher than the first speeds.
Embodiment 22. The method of embodiment 16, further comprising:
   configuring the IC package to route first interconnections from first I/O pads on the IC chip to the first plurality of contact structures for inputting/outputting first signals;
   configuring the IC package to route the second interconnections from the second I/O pads on the IC chip to the plurality of second contact structures for inputting/outputting second signals that are more sensitive to signal attenuation than the first signals.

## Claims

1. An integrated circuit (IC) package, comprising:
a package substrate configured to have a first surface and a second surface being opposite to the first surface;
an IC chip that is interconnected with the package substrate;
a first plurality of contact structures disposed on the first surface of the package substrate to electrically couple the IC package to traces on a printed circuit board (PCB);
a second plurality of contact structures disposed on the second surface of the package substrate, the second plurality of contact structures being configured to electrically couple the IC package to another device via a connective structure that is independent of the PCB.

2. The IC package of claim 1, wherein the second plurality of contact structures is disposed on the second surface in a form of a two-dimensional array of contact structures.

3. The IC package of claim 1 or 2, wherein the second plurality of contact structures is configured to couple a communication cable to a second plurality of I/O pads on the IC chip.

4. The IC package of claim 3, further comprising:
a connector that is attached to the IC package, the connector having a first connector interface configured to electrically connect with the second plurality of contact structures, and having a second connector interface configured to electrically connect with the communication cable.

5. The IC package of claim 3, wherein the second plurality of contact structures includes two contact structures that are electrically coupled to a differential pair of I/O pads on the IC chip, and the two contact structures are configured to electrically couple the differential pair of I/O pads with two conductors in a twin-axial cable.

6. The IC package of claim 5, wherein the second plurality of contact structures includes multiple pairs of contact structures that are electrically coupled to multiple differential pairs of I/O pads on the IC chip, and the multiple pairs of contact structures are configured to mechanically accept a plug for electrically connecting the multiple pairs of contact structures with multiple twin-axial cables; or
wherein the two contact structures are configured to be electrically connected to a port device on the PCB via the twin-axial cable; or
wherein the two contact structures are configured to be electrically connected to a port device that is off of the PCB via the twin-axial cable.

7. The IC package of one of claims 1 to 6, wherein the IC chip is disposed on the second surface, and the second plurality of contact structures is disposed on the second surface in a peripheral area between the IC chip and an edge of the package substrate.

8. The IC package of one of claims 1 to 7, wherein:
the second plurality of contact structures are configured to connect with corresponding contact structures disposed on a second IC package via a multi-layer planar connective structure that is external to the PCB; and/or
wherein:
the second plurality of contact structures are configured to connect with the corresponding contact structures on the second IC package via traces that are disposed within the multi-layer planar connective structure.

9. The IC package of one of claims 1 to 8, wherein:
the second plurality of contact structures are configured to connect with corresponding contact structures on a second IC package via interconnectors that are assembled within a rigid substrate of a package bridge; and/or
wherein:
the second plurality of contact structures are disposed to form multiple groups of contact structures that are configured to respectively connect with corresponding contact structures on multiple second IC packages via respective package bridges.

10. The IC package of one of claims 1 to 9, wherein
the first plurality of contact structures is configured to input/output signals of first speeds; and
the second plurality of contact structures is configured to input/output signals of second speeds that are higher than the first speeds.

11. The IC package of one of claims 1 to 10, wherein
the second plurality of contact structures is configured to couple a second plurality of I/O pads on the IC chip to the other device via the connective structure that causes less signal attenuation than the PCB.

12. A method, comprising:
forming a package substrate of an integrated circuit (IC) package for packaging an IC chip, the package substrate having a first surface and a second surface being opposite to the first surface;
disposing a first plurality of contact structures on the first surface, the first plurality of contact structures being configured to be electrically coupled with traces on a printed circuit board (PCB) when the IC package is mounted to the PCB; and
disposing a second plurality of contact structures on the second surface, the second plurality of contact structures being configured to be electrically coupled with a connective structure that is independent of the PCB, the connective structure coupling the IC chip to a device separate from the IC chip.

13. The method of claim 12, further comprising:
attaching a connector to the IC package with a first connector interface being electrically connected with the second plurality of contact structures; and/or
further comprising:
plugging a communication cable into a second connector interface of the connector to electrically connect the second plurality of contact structures with the communication cable; and/or
further comprising:
plugging the communication cable into the second connector interface of the connector to electrically connect two conductors of a twin-axial cable within the communication cable to two contact structures within the second plurality of contact structures, the two contact structures being connected to a pair of differential inputs/outputs in the IC chip.

14. The method of claim 12 or 13, further comprising:
mounting the IC package to the PCB with the first plurality of contact structures being electrically coupled with the traces on the PCB; and
attaching a multi-layer planar connective structure that is external to the PCB to the IC package to connect the second plurality of contact structures with corresponding contact structures on a second IC package via traces that are disposed in the multi-layer planar connective structure; or
further comprising:
configuring the IC package to route first interconnections from first I/O pads on the IC chip to the first plurality of contact structures for inputting/outputting signals of first speeds;
configuring the IC package to route second interconnections from second I/O pads on the IC chip to the second plurality of contact structures for inputting/outputting signals of second speeds that are higher than the first speeds.

15. The method of one of claims 12 to 14, further comprising:
configuring the IC package to route first interconnections from first I/O pads on the IC chip to the first plurality of contact structures for inputting/outputting first signals;
configuring the IC package to route the second interconnections from the second I/O pads on the IC chip to the plurality of second contact structures for inputting/outputting second signals that are more sensitive to signal attenuation than the first signals.
